(19)

Europäisches
Patentamt

European
Patent Office

Office européen
des brevets

(11) **EP 2 101 456 A1**

(12) **EUROPEAN PATENT APPLICATION**

(43) Date of publication:
**16.09.2009 Bulletin 2009/38**

(51) Int Cl.:
*H04L 27/14* [(2006.01)]     *H04L 27/22* [(2006.01)]
*H03D 3/00* [(2006.01)]     *H01L 21/33* [(2006.01)]

(21) Application number: **08102494.5**

(22) Date of filing: **11.03.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Seiko Epson Corporation
Shinjuku-ku,
Tokyo 163-0811 (JP)**

(72) Inventors:
• **Cairo Molins, Josep Ignasi
EPSON EUROPE ELECTRONICS GmbH
08190 Sant Cugat del Vallés (Barcelona) (ES)**
• **Gil Gali, Ignacio
EPSON EUROPE ELECTRONICS GmbH
08190 Sant Cugat del Valles (Barcelona) (ES)**
• **Lopez Martin, Antonio
31006 Pamplona (ES)**

• **Aguado, Jesús
31006 Pamplona (ES)**
• **Gonzalez Carvajal, Ramón
Asociación de Investigación y Coop
Industrial de Andalucia
41092 Sevilla (ES)**
• **Acosta, Lucía
Asociación de Investigación y Coop
Industrial de Andalucia
41092 Sevilla (ES)**
• **Ramirez Angulo, Jaime
Asociación de Investigación y Coop
Industrial de Andalucia
41092 Sevilla (ES)**

(74) Representative: **Carpintero Lopez, Francisco et al
Herrero & Asociados, S.L.
Alcalá 35
28014 Madrid (ES)**

(54) **Linear combiner**

(57)     The invention refers to a linear combiner for linearly combining at set of N input signals *(i(t), q(t), $V_k^+$-$V_k^-$)*, N≥2, wherein.
- said N input signals are connected by means of respective N capacitors ($C_k$) to a single quasi-floating node (Out, G1, G2);
- said single quasi-floating node is further connected to a dc biasing voltage ($V_{BIAS}$) by means of a component with a very high resistive value (10, 11), such that the current through the quasi-floating node is negligible;
such that the signal at said quasi-floating node (V0, VG1, VG2) is a weighted combination of the input signals ($V_1$, $V_2$, *i(t), q(t), $V_k^+$-$V_k^-$)*

FIG. 2

**Description**

Field of the invention

The present invention is related to the field of wireless telecommunication systems, in particular reception and demodulation of digital coded schemes

Background of the invention

Frequency Shift Keying (FSK) is a common type of modulation used to transmit information between transmitters and receivers. One example is the well known Bluetooth receiver that uses Gaussian FSK (GFSK). The information is modulated in the transmitter and in order to recover such information in the receiver, the signal has to be demodulated, that is, the digital information of the signal has to be extracted, by means of a demodulator.

Zero-crossing demodulators usually have a first analogue part which involves a linear combiner that by linearly combining the in-phase and quadrature signals (I and Q) generates a set of different sub-signals $i_k(t)$ and $q_k(t)$ and also amplitude limiters; and a digital part which generates the output data stream and the symbol synchronization circuit. The number of sub-signals $i_k(t)$-$q_k(t)$ needed depends on the type of signal and the demodulation scheme.

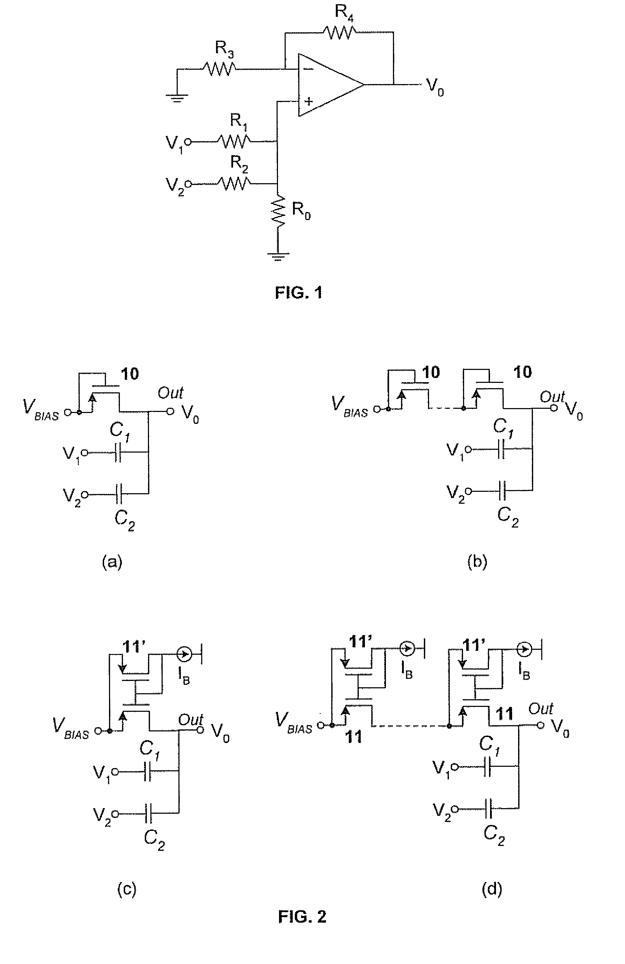

The conventional way to implement a linear combiner and obtain the weighted addition of two input voltages, is by means of operational amplifiers and passive resistors, as shown for example in figure 1 ("Handbook of operational amplifier applications", Texas Instruments Application Report, SBOA092A, October 2001). In the operational amplifier shown, it is well known that $V_0 = a_1 V_1 + a_2 V_2$, where:

$$a_1 = \left(1 + \frac{R_4}{R_3}\right) \frac{R_2 \parallel R_0}{R_1 + R_2 \parallel R_0}$$

$$a_2 = \left(1 + \frac{R_4}{R_3}\right) \frac{R_1 \parallel R_0}{R_2 + R_1 \parallel R_0}$$

However, this implementation shown in fig 1 has the following drawbacks:

- An operational amplifier is required for each linear combination, which involves high power consumption.
- The driving stage is resistively loaded.
- The closed-loop operation of the operational amplifier limits speed
- An input DC offset may saturate the output.

Another implementation can be found in US patent US-3934204, which describes an AM/AGC weighted diversity combiner utilizing the AGC and AM voltages from the AGC loops of a pair of receivers for generating an optimum weighting signal or combining ratio.

Summary of the invention

The invention refers to a linear combiner according to claim 1. Preferred embodiments of the linear combiner are defined in the dependent claim.

The present invention provides a compact circuit for a linear combiner, which overcomes the drawbacks of prior-art linear combiners as described before, since dissipating devices (such as resistors) are not used and the input signals are capacitively coupled to a quasi-floating node which provides a linear combination of the input signals.

A first aspect of the invention relates to a linear combiner for linearly combining a set of N input signals, N being a natural number N≥2, wherein:

- said N input signals are connected by means of respective N capacitors $C_k$ to a single quasi-floating node, whereby the input resistance of the linear combiner is infinite and its static power consumption is null; and wherein
- said single quasi-floating node is further connected to a dc biasing voltage $V_{BIAS}$ by means of a component with a very high resistive value -in the order of gigaohms-i.e., the resistive value of said component is sufficiently high so that the current through the quasi-floating node is negligible;

such that the signal at said quasi-floating node is a linear combination of the input signals.

With the linear combiner of the present invention, a linear combination of several input signals is achieved by means of capacitive division with an independent control of the dc level.

Saturation by input offsets of the linear combiner is avoided since any de offset at the input(s) is not transmitted to the output. It is important e.g. in Zero-IF receivers as the signal is demodulated at baseband frequencies, which makes DC offsets one of the main problems in this kind of receivers.

The component with a very high resistive value is preferably implemented by means of one or more transistors, such that the resulting design is efficient in terms of silicon area.

Such one or more transistors can be worked in the cut-off mode, in diode connection; in this region the current going through such transistor is only the leakage current, and the equivalent resistance is very high Or it is also possible to have one or more transistors working in the subthreshold region This latter preferred embodiment provides a better precision when the DC voltage in the single node is established.

In either case, if there is more than one transistor, they are preferably connected in series, such that the total resistance value is higher

The quasi-floating node of the linear combiner is preferably connected to an amplifying stage, which amplifying stage is implemented by means of two transistors both working as Quasi-Floating Gate (QFG) transistors. Further, the amplifying stage preferably drives a latched comparator to achieve amplitude limitation of the input signals.

In such case, the gate voltages $V_{G1}$, $V_{G2}$ of the two QFG transistors are:

$$V_{G1} = V_{BIAS} + \sum_{k=1}^{N} \frac{V^+_k \cdot C_k}{C_{TOT}}$$

$$V_{G2} = V_{BIAS} + \sum_{k=1}^{N} \frac{V^-_k \cdot C_k}{C_{TOT}}$$

where $V_k^+$ and $V_k^-$ represent the N differential input signals and:

$$C_{TOT} = \sum_{k=1}^{N} C_k \, .$$

The amplifying stage can be any of a preamplifier, an operational amplifier or a differential amplifier.

Advantages of the proposed linear combiner are the following:

- Linear combination of the inputs is carried out with zero quiescent power consumption.
- Comparator inputs can have rail-to-rail swing by properly choosing $V_{BIAS}$, $C_1$, $C_2$-$C_N$.
- The comparator is insensitive to the offset of inputs signals, since the dc level at the input of the preamplifier is set to $V_{BIAS}$ regardless of the input signals.

A further aspect of the invention relates to a demodulator for detecting frequency-modulated signals, wherein said signals comprise an in-phase component (*i(t)*) and a quadrature component (*q(t)*), the demodulator comprises:

- a set of $N_1$ linear combiners as defined herein-before, for generating a plurality of $N_1/2$ in-phase signals ($i_k(t)$) and a plurality of $N_1/2$ quadrature signals ($q_k(t)$), where $0 \leq k \leq N_1/2-1$.

The demodulator may further comprise:

- a plurality of $N_1$ amplitude limiters, each of them being placed at the output of each of said $N_1$ linear combiners, for

providing a digital code associated to the respective in-phase ($i_k(t)$) or quadrature ($q_k(t)$) signal at the output of which they are placed, wherein said digital code represents the phase quantization sector of said in-phase ($i_k(t)$) and quadrature ($q_k(t)$) signals;

- decoding means providing a decoded symbol having $\log_2(2N_1)$ bits, each of said $\log_2(2N_1)$ bits being outputted in parallel;
- a set of $\log_2(2N_1)$ flip-flops, each of them being placed at the output of each of the $\log_2(2N_1)$ outputted bits, for delaying said $\log_2(2N_1)$-bit symbol previously outputted;
- comparison means for comparing said $\log_2(2N_1)$ decoded symbol to said delayed $\log_2(2N_1)$-bit decoded symbol to detect direction of the phase shift and thus to detect the data signal

The demodulator may be part of a zero-IF receiver.

Brief description of the drawings

To complete the description and in order to provide for a better understanding of the invention, a set of drawings is provided. Said drawings form an integral part of the description and illustrate preferred embodiments of the invention, which should not be interpreted as restricting the scope of the invention, but just as examples of how the invention can be embodied. The drawings comprise the following figures:

Figure 1 shows a conventional linear combiner.
Figures 2(a), 2(b), 2(c) and 2(d) show several possible implementations of the linear combiner of the present invention.
Figure 3 shows a first preferred embodiment of a linear combiner plus amplitude limiter for two single-ended input signals according to the invention.
Figure 4 shows a second preferred embodiment of a linear combiner plus amplitude limiter for two differential inputs according to the invention.
Figure 5 shows a further embodiment of a linear combiner plus amplitude limiter according to the invention, having N input signals.

Detailed description of the preferred embodiments

Reference will now be made in detail to a preferred embodiment of the method of the present invention.
As indicated before, Figure 1 shows the conventional way to implement a linear combiner and obtain at the output a weighted addition of two input voltages, by means of an operational amplifier and passive resistors.
Figures 2(a), 2(b), 2(c) and 2(d) show different possible embodiments of the linear combiner of the invention:
In Figure 2(a) the component with a very high resistive value is implemented by means of a transistor 10 working in cut-off in diode connection to a biasing dc voltage $V_{BIAS}$. And in Figure 2(b) the component with a very high resistive value is implemented by means of a group of series transistors 10 in diode connection
In Figure 2(c) the component with a very high resistive value is implemented by means of a transistor 11 working in the sub-threshold region. And in Figure 2(b) the component with a very high resistive value is implemented by means of a group of transistors 11 connected in series, which transistors are working in the sub-threshold region.
In the implementation shown in figures 2(c) and 2(d), when the transistor is working in the sub-threshold region, it is important that the current through the transistor is almost negligible, so that the corresponding equivalent resistance be very high (in the order of gigaohms). In order to do so, as shown in both figures 2(c) and 2(d), a further transistor 11' may be used, connected as a current mirror, such that the current through the transistor(s) 11 is controlled by means of the current $I_B$, and therefore it can be made as low as desired. An additional advantage of this lay-out is that the value of the equivalent resistance can also be controlled by means of varying $I_B$.
In any of the embodiments shown in figures 2(a)-2(d), the signal added to $V_{BIAS}$ at the single common quasi-floating node is:

$$V_o(f) = \frac{j\omega R_{big} C_1}{1 + j\omega R_{big}(C_1 + C_2)} V_1(f) + \frac{j\omega R_{big} C_2}{1 + j\omega R_{big}(C_1 + C_2)} V_2(f)$$

where $R_{big}$ represents the equivalent resistance of the component with a very high resistive value. So the transistors implement an extremely high resistance that sets the DC input level to $V_{BIAS}$. That is, the DC voltage at said node is $V_{BIAS}$ and the AC voltage at that node is the result of filtering the input voltages with a first-order high-pass filter, with a cut-off frequency of $1/[2\pi R_{big}(C_1+C_2)]$.

In view of the high value of $R_{big}$, the cutoff frequency of that high-pass filter is very low (less than 1 Hz), whereby the input signals lose their DC level, but they keep their AC contents. Therefore, the voltage at that node (at the output of the linear combiner) can be approximated to:

$$V_0 = V_{BIAS} + a_1 (V_1 - V_{1DC}) + a_2 (V_2 - V_{2DC})$$

where:

$$a_1 = \frac{C_1}{C_1 + C_2}$$

$$a_2 = \frac{C_2}{C_1 + C_2}$$

The linear combiner of the present invention may be used, for instance, as part of a demodulator in a zero-IF receiver.

In this case of a zero-IF receiver, the down-conversion from the input RF signal is done at the DC level, so the method for demodulation used is based on zero-crossing detection. It greatly simplifies gain control of the receiver due to the use of amplitude limiters, and it allows for simple digital detection without requiring multibit analogue to digital converters (ADC).

Provided two quadrature signals at the receiver $i(t)$ and $q(t)$ (in-phase and quadrature, respectively), it is necessary to generate a set of sub-signals $i_k(t)$-$q_k(t)$ which are combinations of these signals for the demodulation. The number of sub-signals $i_k(t)$-$q_k(t)$ needed in each case depends on the type of signal and the modulation scheme. In the present example, eight combinations of the signal will be generated, which implies a division of the instantaneous phase in sixteen sectors with eight axes This provides the phase resolution that can obtained, which is needed in order to demodulate the phase or frequency modulated signal, by detecting the zero crossing angle or phase. It is necessary that the received waveform crosses zero at least once or more per symbol.

According to the demodulator requirements assumed in the present example, such signal combination is the following:

$$i_0(t) = i(t)$$

$$i_1(t) = i(t) \cdot \cos(\pi/8) + q(t) \cdot \sin(\pi/8) \approx 0.924 \cdot i(t) + 0.383 \cdot q(t)$$

$$i_2(t) = i(t) \cdot \cos(\pi/4) + q(t) \cdot \sin(\pi/4) \approx (1/\sqrt{2}) [i(t) + q(t)]$$

$$i_3(t) = i(t) \cdot \cos(3\pi/8) + q(t) \cdot \sin(3\pi/8) \approx 0.383 \cdot i(t) + 0.924 \cdot q(t)$$

[1]

and:

$$q_0(t) = q(t)$$

$$q_1(t) = q(t) \cdot \cos(\pi/8) - i(t) \cdot \sin(\pi/8) \approx 0.924 \cdot q(t) - 0.383 \cdot i(t)$$

$$q_2(t) = q(t) \cdot \cos(\pi/4) - i(t) \cdot \sin(\pi/4) \approx (1/\sqrt{2}) [q(t) - i(t)]$$

$$q_3(t) = q(t) \cdot \cos(3\pi/8) - i(t) \cdot \sin(3\pi/8) \approx 0.383 \cdot q(t) - 0.924 \cdot i(t)$$

The set of signals that has to be generated is a linear combination of the input signals, by means of product and additions.

To simplify the circuit, note that for the linear combinations to be implemented:

$$i_1(t) = i(t) \cdot \cos(\pi/8) + q(t) \cdot \sin(\pi/8) = \cos(\pi/8) \cdot [i(t) + q(t) \cdot \mathrm{tg}(\pi/8)]$$

$$i_3(t) = i(t) \cdot \cos(3\pi/8) + q(t) \cdot \sin(3\pi/8) \approx \cos(3\pi/8) \cdot [i(t) + q(t) \cdot \mathrm{tg}(3\pi/8)]$$

and

$$q_1(t) = q(t) \cdot \cos(\pi/8) - i(t) \cdot \sin(\pi/8) = \cos(\pi/8) \cdot [q(t) - i(t) \cdot \mathrm{tg}(\pi/8)]$$

$$q_3(t) = q(t) \cdot \cos(3\pi/8) - i(t) \cdot \sin(3\pi/8) \approx \cos(3\pi/8) \cdot [q(t) - i(t) \cdot \mathrm{tg}(3\pi/8)]$$

As amplitude hard-limitation is employed after the linear combiner, the scaling factors multiplying the linear combinations of $i_k(t)$ and $q_k(t)$ need not be implemented, so the final expressions may be:

$$i_0' = i(t)$$

$$i_1'(t) = i(t) + q(t) \cdot \mathrm{tg}(\pi/8) = i(t) + 0.414 \cdot q(t)$$

$$i_2'(t) = i(t) + q(t)$$

$$i_3'(t) = i(t) + q(t) \cdot \mathrm{tg}(3\pi/8) = i(t) + 2.414 \cdot q(t)$$

$$[2]$$

and:

$$q_0' = q(t)$$

$$q_1'(t) = q(t) - i(t) \cdot \mathrm{tg}(\pi/8) = q(t) - 0.414 \cdot i(t)$$

$$q_2'(t) = q(t)-i(t)$$

$$q_3'(t) = q(t)-i(t) \cdot tg(3\pi/8) = q(t)-2.414 \cdot i(t)$$

So finally the first set of expressions [1] for the sub-signals $i_k(t)$ and $q_k(t)$, which would require twelve multiplications and six adding circuits, is simplified to the latter set [2] of simplified expressions, which requires just only four multipliers.

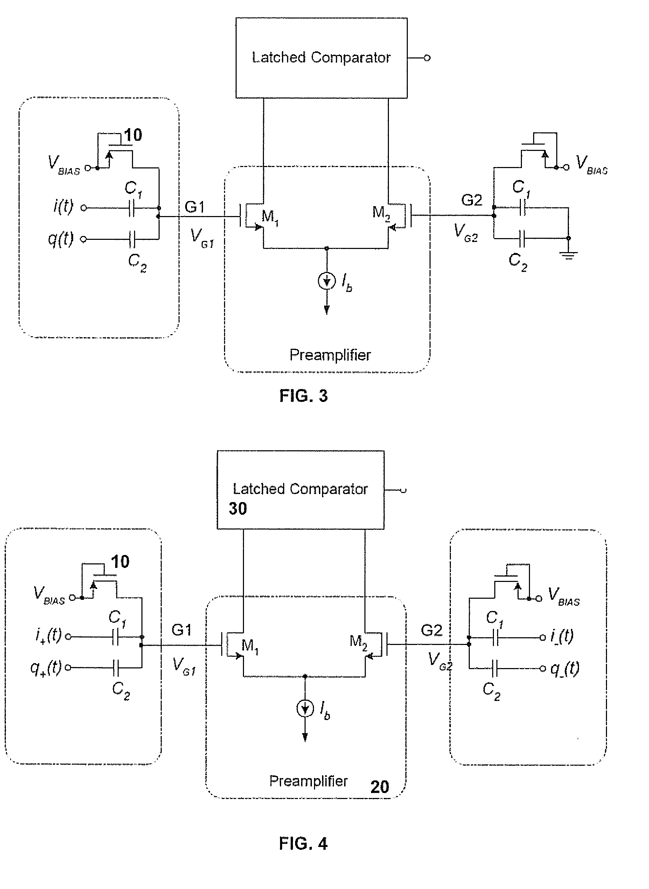

The linear combiner in this case is implemented by means of eight identical linear combiner circuits, a sample of which has already been described and shown in figures 2(a)-2(d); each linear combiner will preferably be further connected to a limiting amplifier portion consisting of a differential preamplifier 20 and a latched comparator 30 (figure 3).

Each combined voltage $V_{G1}$ and $V_{G2}$ is applied at the input of a differential preamplifier 20, the input transistors $M_1$ and $M_2$ of said preamplifier working as QFG transistor

The gate voltages of the QFG transistors $M_1$ and $M_2$ are:

$$V_{G1} = V_{BIAS} + \frac{C_1}{C_1 + C_2} i(t) + \frac{C_2}{C_1 + C_2} q(t) \qquad V_{G2} = V_{BIAS}$$

Hence by properly choosing $C_1$ and $C_2$ the weighting factors required are implemented.

A latched comparator 30 has been added after the preamplifier, in order to act, in combination with the preamplifier, as an amplitude limiter for the differential signal at the input of the preamplifier.

The output of the latched comparator is a square signal where zero crossings occur when $V_{G1}=V_{G2}$, i.e., when:

$$\frac{C_1}{C_1 + C_2} i(t) + \frac{C_2}{C_1 + C_2} q(t) = 0 \; ,$$

i.e. when a given linear combination of the in-phase and quadrature signals is zero, as required in a zero-crossing detector.

Let's consider the following example, where one of the signal combinations to be obtained as required by the demodulator is the following:

$$i_1(t)=i(t)+0.4 \cdot q(t).$$

The values of the two capacitors $C_1$ and $C_2$ have to be chosen so as to comply with such combination.

As indicated before, the analogue part of the demodulator involves the linear combiner, the output of which is connected to an amplitude limiter. Thus, the total amplitude of the signal is not important and the previous equation can be adjusted to the following:

$$i_1(t)=(1/1.4) \cdot i(t)+(0.4/1.4) \cdot q(t)$$

Then, it is necessary to chose $C_1$ and $C_2$ such that $C_1/(C_1+C_2)=1/1.4$ and $C_2/(C_1+C_2)=0.4/1.4$. Thus, the chosen values are $C_2=0.4C_1$.

It is thus an important factor that an embodiment of the linear combiner of the invention is used, thus capacitively coupling the input voltages to the floating gate of said QFG transistors.

Figure 4 shows a second preferred embodiment of a linear combiner plus amplitude limiter for differential input signals $i_+(t)-i_-(t)$ and $q_+(t)-q_-(t)$.

In this case, an autozeroing circuit can be included to remove the offset of the input differential pair. Differential pairs usually have an input offset, which should be removed to achieve more accuracy. This offset is conventionally removed using autozeroing techniques Such well-known techniques can be easily incorporated in the preamplifier of Figure 4.

The linear combiner as described hereinbefore has been developed for a specific type of Demodulator Nevertheless, the linear combiner of the present invention can be applied to any type of demodulator or circuit which requires a linear combination of signals.

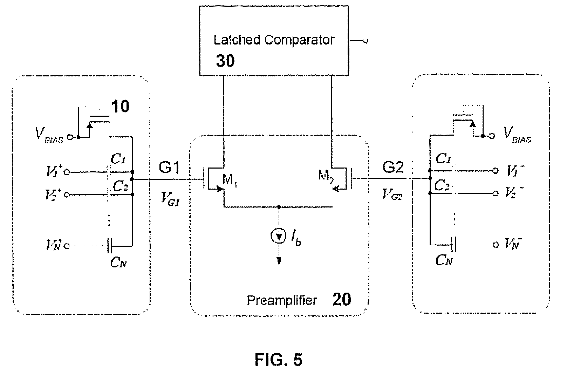

That is, the linear combiner of the invention is not only valid for two input signals, but it can be used to combine N input signals. Figure 5 shows how it is possible to generalise to N input signals, showing a linear combiner having N differential input signals $V_1^+$- $V_1^-$, $V_2^+$- $V_2^-$, ... $V_N^+$- $V_N^-$.

The linear combiner circuit consists of capacitive dividers formed by N capacitors $C_1$, $C_2$,... $C_N$ and a MOS transistor 10 in diode connection to $V_{BIAS}$ that acts as a resistor for biasing.

Each combined voltage $V_{G1}$ and $V_{G2}$ is applied at the input of a differential preamplifier 20, the input transistors $M_1$ and $M_2$ of said preamplifier working as QFG transistors

The gate voltages of the QFG transistors $M_1$ and $M_2$ in this case are as follows:

$$V_{G1} = V_{BIAS} + \sum_{k=1}^{N} \frac{V^+_k \cdot C_k}{C_{TOT}} \qquad V_{G2} = V_{BIAS} + \sum_{k=1}^{N} \frac{V^-_k \cdot C_k}{C_{TOT}}$$

where:

$$C_{TOT} = \sum_{k=1}^{N} C_k$$

It is worth mentioning that while using standard techniques with resistances and operational amplifiers, the power consumption of the resulting circuit can be in the order of some microwatts, in the linear combiner of the present invention there is no quiescent power consumption, or it is negligible, that is to say, about three or four orders of magnitude lower.

As indicated before, the present invention relates to a linear combiner It is to be understood that the above disclosure is an exemplification of the principles of the invention and does not limit the invention to the illustrated embodiments.

**Claims**

1.   Linear combiner for linearly combining at set of N input signals (*i(t)*, *q(t)*, $V_k^+$-$V_k^-$), N≥2, wherein:

- said N input signals are connected by means of respective N capacitors ($C_k$) to a single quasi-floating node (Out, G1, G2);
- said single quasi-floating node is further connected to a dc biasing voltage ($V_{BIAS}$) by means of a component with a resistive value (10, 11) being the resistive value sufficiently high such that the current through the quasi-floating node is negligible;

the signal at said quasi-floating node ($V_0$, $V_{G1}$, $V_{G2}$) being a weighted combination of the input signals ($V_1$, $V_2$, *i(t)*, *q(t)*, $V_k^+$-$V_k^-$).

2.   Linear combiner according to claim 1, wherein the element with a very-high resistive value is implemented by means of a transistor or a group of transistors in diode connection, in the case of a group of transistors they are connected in series.

3.   Linear combiner according to claim 1, wherein the element with a very-high resistive value is implemented by means of a transistor working in the subthreshold region or by means of a group of transistors working in the subthreshold region, when a group of transistors they are in series connection

4.   Demodulator for detecting frequency-modulated signals, wherein said signals comprise an in-phase component (*i*

*(t))* and a quadrature component (*q(t)*), the modulator comprises:

- a set of $N_1$ linear combiners according to any preceding claim, for generating a plurality of $N_1/2$ in-phase signals (*$i_k(t)$*) and a plurality of $N_1/2$ quadrature signals (*$q_k(t)$*), where $0 \leq k \leq N_1/2-1$.

**5.** Demodulator according to claim 4, wherein each quasi-floating node of the $N_1$ linear combiners is connected to an amplifying stage (20), which each amplifying stage is implemented by means of two transistors ($M_1$, $M_2$) both working as QFG transistors.

**6.** Demodulator according to claim 5, wherein in each of the $N_1$ amplifying stages the gate voltages ($V_{G1}$, $V_{G2}$) of the QFG transistors $M_1$ and $M_2$ are:

$$V_{G1} = V_{BIAS} + \sum_{k=1}^{N} \frac{V^+_k \cdot C_k}{C_{TOT}}$$

$$V_{G2} = V_{BIAS} + \sum_{k=1}^{N} \frac{V^-_k \cdot C_k}{C_{TOT}}$$

where:

$$C_{TOT} = \sum_{k=1}^{N} C_k$$

**7.** Demodulator according to any of claims 5-6, wherein each amplifying stage is connected to a latched comparator (30) in order to achieve amplitude limitation of the input signals.

**8.** Demodulator according to claim 4, further comprising:

- a plurality of $N_1$ amplitude limiters, each of them being placed at the output of each of said $N_1$ linear combiners, for providing a digital code associated to the respective in-phase (*$i_k(t)$*) or quadrature (*$q_k(t)$*) signal at the output of which they are placed, wherein said digital code represents the phase quantization sector of said in-phase (*$i_k(t)$*) and quadrature (*$q_k(t)$*) signals;
- decoding means providing a decoded symbol having $\log_2(2N_1)$ bits, each of said $\log_2(2N_1)$ bits being outputted in parallel;
- a set of $\log_2(2N_1)$ flip-flops, each of them being placed at the output of each of the $\log_2(2N_1)$ outputted bits, for delaying said $\log_2(2N_1)$-bit symbol previously outputted;
- comparison means for comparing said $\log_2(2N_1)$-bit decoded symbol to said delayed $\log_2(N_1)$-bit decoded symbol to detect direction of the phase shift and thus to detect the data signal.

**9.** Demodulator according to any of claims 4-8, wherein said demodulator is part of a zero-IF receiver.

FIG. 1

(a)

(b)

(c)

(d)

FIG. 2

Latched Comparator

**10**

$V_{BIAS}$

$C_1$

$i(t)$

$q(t)$

$C_2$

G1

$V_{G1}$

$M_1$

$M_2$

G2

$V_{G2}$

$C_1$

$V_{BIAS}$

$C_2$

$I_b$

Preamplifier

**FIG. 3**

Latched Comparator

**30**

**10**

$V_{BIAS}$

$C_1$

$i_+(t)$

$q_+(t)$

$C_2$

G1

$V_{G1}$

$M_1$

$M_2$

G2

$V_{G2}$

$C_1$

$V_{BIAS}$

$i_-(t)$

$q_-(t)$

$C_2$

$I_b$

Preamplifier  **20**

**FIG. 4**

FIG. 5

Europäisches
Patentamt

European
Patent Office

Office européen
des brevets

# EUROPEAN SEARCH REPORT

Application Number

EP 08 10 2494

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NASS O ET AL: "Low-voltage pseudo floating-gate reconfigurable linear threshold elements" IEEE INTERNATIONAL JOINT CONFERENCE ON NEURAL NETWORKS, vol. 2, 31 July 2005 (2005-07-31), pages 675-680, XP010866038 PISCATAWAY, NJ, USA,IEEE, US ISBN: 978-0-7803-9048-5 | 1-7,9 | INV. H04L27/14 H04L27/22 H03D3/00 ADD. H01L21/33 |
| Y | * abstract; figures 1-3,5,6,8,10 * sections I-III ----- | 8 | |
| X | GONZALEZ-CARVAJAL R ET AL: "A new family of very low-voltage analog circuits based on quasi-floating-gate transistors" IEEE TRANSACTIONS ON CIRCUITS AND SYSTEMS, vol. 50, no. 5, 1 May 2003 (2003-05-01), pages 214-220, XP011096141 IEEE SERVICE CENTER, NEW YORK, NY, US ISSN: 1057-7130 | 1-7,9 | |
| Y | * figure 1 * sections I, II ----- | 8 | TECHNICAL FIELDS SEARCHED (IPC) H04L H01L H03D H04B G11C H03K |
| X | CARVAJAL R G ET AL: "Very Low-Voltage Analog Signal Processing Based on Quasi-Floating Gate Transistors" IEEE JOURNAL OF SOLID-STATE CIRCUITS, vol. 39, no. 3, 1 March 2004 (2004-03-01), pages 434-442, XP011108372 IEEE SERVICE CENTER, PISCATAWAY, NJ, US ISSN: 0018-9200 | 1-7,9 | |
| Y | * abstract; figures 1,4,5 * sections I, II, IV.A, IV.D ----- -/-- | 8 | |

The present search report has been drawn up for all claims

| Place of search | Date of completion of the search | Examiner |
|---|---|---|
| The Hague | 9 January 2009 | Faber, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 08 10 2494

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2004/040658 A (TOUMAZ TECHNOLOGY LTD [GB]; LANDE TOR SVERRE [NO]) 13 May 2004 (2004-05-13) | 1-7,9 | |
| Y | * abstract; figures 1,3,4,8 * <br> * page 2, lines 5-10 * <br> * page 3, line 12 - line 29 * <br> * page 7, line 30 - page 8, line 30 * <br> * page 12, line 6 - line 12 * <br> ----- | 8 | |
| Y | SAMADIAN S ET AL: "DEMODULATORS FOR A ZERO-IF BLUETOOTH RECEIVER" IEEE JOURNAL OF SOLID-STATE CIRCUITS, vol. 38, no. 8, 1 August 2003 (2003-08-01), pages 1393-1396, XP001170979 IEEE SERVICE CENTER, PISCATAWAY, NJ, US ISSN: 0018-9200 | 8 | |
| A | * abstract; figures 2,5 * sections II, III <br> ----- | 4,9 | |

TECHNICAL FIELDS
SEARCHED      (IPC)

The present search report has been drawn up for all claims

| Place of search | Date of completion of the search | Examiner |
|---|---|---|
| The Hague | 9 January 2009 | Faber, Thomas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

.............................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 08 10 2494

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2009

| Patent document cited in search report | Publication date | Patent family member(s) | | Publication date |
|---|---|---|---|---|
| WO 2004040658 A | 13-05-2004 | AU | 2003286194 A1 | 25-05-2004 |
| | | CN | 1708861 A | 14-12-2005 |
| | | DE | 10393631 T5 | 03-11-2005 |
| | | GB | 2395065 A | 12-05-2004 |
| | | GB | 2409768 A | 06-07-2005 |
| | | US | 2006086969 A1 | 27-04-2006 |

**EP 2 101 456 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 3934204 A

### Non-patent literature cited in the description

- Handbook of operational amplifier applications. October 2001